# EUROPEAN PATENT APPLICATION

(11) **EP 3 817 526 A1**
(43) Date of publication of application: **05.05.2021**
(21) Application number: 19826058.0
(22) Date of filing: 30.05.2019
(51) Int. Cl.: H05K 3/38, B23K 26/351, C23F 1/30, C23F 1/44, C25D 5/02, C25D 5/56, H05K 3/08

(54) **METHOD FOR PRODUCING MOLDED BODY HAVING METAL PATTERN**

(30) Priority: 26.06.2018 JP 2018120976
(71) Applicant: DIC Corporation, Tokyo 174-8520 (JP)
(72) Inventor: FUKAZAWA, Norimasa, Takaishi-shi, Osaka 592-0001 (JP); FUJIKAWA, Wataru, Takaishi-shi, Osaka 592-0001 (JP); SHIRAKAMI, Jun, Takaishi-shi, Osaka 592-0001 (JP)
(74) Representative: TBK
(86) International application number: PCT/JP2019/021513
(87) International publication number: WO 2020/003879

(57) **Abstract**

The present invention provides a method for producing a shaped article having a metal pattern on an electrically insulating shaped article. The method includes step 1, forming an electrically conductive metal layer (M1) on an electrically insulating shaped article (A), the electrically conductive metal layer (M1) containing silver particles; step 2, removing part of the electrically conductive metal layer (M1) to separate the electrically conductive metal layer (M1) into an electrically conductive metal layer in the pattern region (PM1), the pattern region being the region in which the pattern is to be formed, and an electrically conductive metal layer in the no-pattern region (NPM1), the no-pattern region being the region in which the pattern is not to be formed; step 3, forming a patterned metal layer (PM2) on the electrically conductive metal layer in the pattern region (PM1) by electrolytic plating; and step 4, removing the electrically conductive metal layer in the no-pattern region (NPM1) using an etchant. This production method allows the manufacturer to form a strongly adhering metal pattern without roughening the surface of the shaped article and to produce a shaped article having a metal pattern on its surface without requiring vacuum equipment or special equipment.

## Description

### Technical Field

The present invention relates to a method for producing a shaped article that has a metal pattern on a planar or three-dimensional solid electrically insulating shaped article.

### Background Art

A known example of a method for forming a metal pattern on an electrically insulating shaped article is by creating pattern and no-pattern regions, in which the pattern is to be formed and not to be formed, respectively, on the surface of the shaped article by double molding, i.e., shaping two materials varying in the rate of plating deposition, and then forming the metal pattern by taking advantage of the difference in the rate of plating deposition. This method, however, is troublesome and costly because it requires two shaping steps, and it is difficult to reproduce a fine-pitch pattern by molding. This method has also caused problems such as that the plating solution penetrates into the interface between the two resin materials and stays there.

As a method that involves no double molding, there is disclosed the use of a plating seed layer formed on the entire surface of a shaped article (e.g., see PTL 1). In this method, an article of an electrically insulating material, such as polyimide, ABS, polyetherimide, a liquid-crystal polymer, or alumina ceramic, is used as a shaped substrate. Its surface is roughened through a treatment that renders the surface uneven, for example with a chromic acid solution, an aqueous solution of potassium hydroxide, or a phosphoric acid solution, and then a seed layer for electrolytic plating is formed thereon. The portion of the formed seed layer corresponding to the outline of the metal pattern that finally becomes wiring is removed by irradiation with laser light, and this also separates the seed layer into electrically conductive and electrically nonconductive areas. Then only the area of the wiring pattern is electrolytically plated with copper to form a thicker copper film in the area of the wiring pattern than in the no-wiring area. Then soft etching is carried out to form a wiring pattern of copper on the surface of the shaped article.

With the technology of PTL 1, however, it is arduous to form a fine-pitch pattern, or the formation of a fine-pitch pattern is difficult, because of the roughened surface of the shaped article. For the purpose of wiring for the transmission of radiofrequency signals, furthermore, this technology has disadvantages such as a transmission loss. The roughening of the surface of the shaped article also tends to cause the surface of the plating film to be rough and matte accordingly.

PTL 1 discloses another method for forming a plating seed layer, in which the surface of the shaped article is roughened, or rendered uneven, through activation by plasma treatment instead of treatment with a chemical, and then copper is sputter-deposited on the entire surface. Because of the use of sputtering to form a seed layer for electrolytic plating, this method has disadvantages such as the need for expensive vacuum equipment, low production efficiency, difficulty in application to heat-vulnerable substrates because the substrate is put under a high-temperature load during the formation of the film by sputtering, and difficulty in obtaining a strongly adhering metal film.

As a method whereby strong adhesion can be achieved without roughening of the surface of the shaped article and in which no vacuum equipment is involved, there is disclosed the use of a plastic shaped article with fine particles containing a metal element dispersed on its surface portion (e.g., see PTL 2). The disclosed ways to obtain a plastic shaped article with fine particles containing a metal element dispersed on its surface portion are by making an alcohol or reducing agent penetrate into the plastic shaped article and exposing the article to high-pressure carbon dioxide containing a metal complex, and by dissolving high-pressure carbon dioxide containing a metal complex into molten resin in the plasticizing cylinder for the injection molding carried out to produce the plastic shaped article and then injecting the molten resin into a mold to shape it into the plastic shaped article. This method has disadvantages such as the need for special equipment for the use of high-pressure carbon dioxide to form fine particles containing a metal element on the surface of the plastic shaped article and that the impregnation with a metal element causes the plastic shaped article to have different characteristics between its surface portion and bulk.

### Citation List

### Patent Literature

PTL 1: Japanese Unexamined Patent Application Publication No. 7-66533
PTL 2: Japanese Unexamined Patent Application Publication No. 2010-80495

### Summary of Invention

### Technical Problem

The problem to be solved by the present invention is to provide a method for producing a shaped article whereby a strongly adhering metal pattern can be formed without roughening the surface of the shaped article and whereby a shaped article having a metal pattern can be produced without requiring vacuum equipment or special equipment. Solution to Problem

After extensive research to solve the above problem, the inventors found that the formation of a strongly adhering metal pattern without roughening the surface of the shaped article can be achieved by forming an electrically conductive metal layer containing silver particles on the surface of the shaped article, removing part of the electrically conductive metal layer to separate the metal layer into pattern and no-pattern regions, on which the pattern is to be formed and not to be formed, respectively, forming a metal layer on the pattern region by electrolytic plating, and then removing the metal layer in the no-pattern region using an etchant. By this approach, furthermore, a shaped article having a metal pattern on its surface can be produced without requiring vacuum equipment or special equipment. The present invention is based on these findings.

That is, the present invention provides a method for producing a shaped article having a metal pattern on an electrically insulating shaped article that includes step 1, forming an electrically conductive metal layer (M1) on an electrically insulating shaped article (A), the electrically conductive metal layer (M1) containing silver particles; step 2, removing part of the electrically conductive metal layer (M1) to separate the electrically conductive metal layer (M1) into an electrically conductive metal layer in a pattern region (PM1), the pattern region being a region in which the pattern is to be formed, and an electrically conductive metal layer in a no-pattern region (NPM1), the no-pattern region being a region in which the pattern is not to be formed; step 3, forming a patterned metal layer (PM2) on the electrically conductive metal layer in the pattern region (PM1) by electrolytic plating; and step 4, removing the electrically conductive metal layer in the no-pattern region (NPM1) using an etchant.

The present invention also provides a method for producing a shaped article having a metal pattern on an electrically insulating shaped article that includes step 1', forming a primer layer (B) on an electrically insulating shaped article (A) and then forming an electrically conductive metal layer (M1) on the primer layer (B), the electrically conductive metal layer (M1) containing silver particles; step 2, removing part of the electrically conductive metal layer (M1) to separate the electrically conductive metal layer (M1) into an electrically conductive metal layer in a pattern region (PM1), the pattern region being a region in which the pattern is to be formed, and an electrically conductive metal layer in a no-pattern region (NPM1), the no-pattern region being a region in which the pattern is not to be formed; step 3, forming a patterned metal layer (PM2) on the electrically conductive metal layer in the pattern region (PM1) by electrolytic plating; and step 4, removing the electrically conductive metal layer in the no-pattern region (NPM1) using an etchant. Advantageous Effects of Invention

The methods according to the present invention for producing a shaped article having a metal pattern allow the manufacturer to produce a shaped article in a planar or three-dimensional solid shape that has a strongly adhering and smooth-surfaced metal pattern on its surface without requiring complicated double molding or troublesome operations such as exposure and development using a photoresist in a darkroom and without the use of expensive vacuum equipment. By the methods according to the present invention for producing a shaped article having a metal pattern, therefore, manufacturers can provide high-density and high-performance printed wiring boards and molded interconnect devices (MID) in different shapes and sizes at low cost. Thus the present invention has high industrial applicability in the field of printed wiring. The methods according to the present invention for producing a shaped article having a metal pattern can also be used for various electronic components that have a patterned metal layer on the surface of a substrate. For example, the methods can also be applied to connectors, shields against electromagnetic waves, and RFID and other antennas.

The purposes of use of shaped articles having a metal pattern produced by the methods according to the present invention for producing a shaped article having a metal pattern, furthermore, are not limited to electronic components but also include functional components, decorative plating, etc., that have a patterned metal layer on shaped articles in different shapes and sizes.

### Brief Description of Drawings

[Fig. 1] Fig. 1 is a schematic view of a workpiece after the formation of an electrically conductive metal layer on an electrically insulating shaped article.
[Fig. 2] Fig. 2 is a schematic view of a workpiece after the separation of the electrically conductive metal layer into an electrically conductive metal layer in the pattern region and an electrically conductive metal layer in the no-pattern region.
[Fig. 3] Fig. 3 is a schematic view of a workpiece after the formation of a patterned metal layer on the electrically conductive metal layer in the pattern region by electrolytic plating.
[Fig. 4] Fig. 4 is a schematic view of a workpiece after the removal of the electrically conductive metal layer in the no-pattern region using an etchant.

### Description of Embodiments

The present invention is a method for producing a shaped article having a metal pattern on an electrically insulating shaped article that includes step 1, forming an electrically conductive metal layer (M1) on an electrically insulating shaped article (A), the electrically conductive metal layer (M1) containing silver particles; step 2, removing part of the electrically conductive metal layer (M1) to separate the electrically conductive metal layer (M1) into an electrically conductive metal layer in the pattern region (PM1), the pattern region being the region in which the pattern is to be formed, and an electrically conductive metal layer in the no-pattern region (NPM1), the no-pattern region being the region in which the pattern is not to be formed; step 3, forming a patterned metal layer (PM2) on the electrically conductive metal layer in the pattern region (PM1) by electrolytic plating; and step 4, removing the electrically conductive metal layer in the no-pattern region (NPM1) using an etchant.

A more preferred embodiment of the present invention is a method for producing a shaped article having a metal pattern on an electrically insulating shaped article that includes step 1', forming a primer layer (B) on an electrically insulating shaped article (A) and then forming an electrically conductive metal layer (M1) on the primer layer (B), the electrically conductive metal layer (M1) containing silver particles; step 2, removing part of the electrically conductive metal layer (M1) to separate the electrically conductive metal layer (M1) into an electrically conductive metal layer in the pattern region (PM1), the pattern region being the region in which the pattern is to be formed, and an electrically conductive metal layer in the no-pattern region (NPM1), the no-pattern region being the region in which the pattern is not to be formed; step 3, forming a patterned metal layer (PM2) on the electrically conductive metal layer in the pattern region (PM1) by electrolytic plating; and step 4, removing the electrically conductive metal layer in the no-pattern region (NPM1) using an etchant.

Examples of materials for the electrically insulating shaped article (A) used in step 1 or 1' of the present invention include polyimide resins, polyamide-imide resins, polyamide resins, polyethylene terephthalate resins, polybutylene terephthalate resins, polyethylene naphthalate resins, polycarbonate resins, acrylonitrile-butadienestyrene (ABS) resins, polyarylate resins, polyacetal resins, polymethyl (meth)acrylate and other acrylic resins, polyvinylidene fluoride resins, polytetrafluoroethylene resins, polyvinyl chloride resins, polyvinylidene chloride resins, graft copolymers of vinyl chloride resins with acrylic resins, polyvinyl alcohol resins, polyethylene resins, polypropylene resins, urethane resins, cycloolefin resins, polystyrene, liquid-crystal polymers (LCPs), polyether ether ketone (PEEK) resins, polyphenylene sulfide (PPS), polyphenylene sulfone (PPSU), cellulose nanofiber, silicon, silicon carbide, gallium nitride, sapphire, ceramics, glass, diamond-like carbon (DLC), and alumina.

A resin substrate that contains a thermosetting resin and an inorganic filler is also suitable for use as the electrically insulating shaped article (A). Examples of thermosetting resins include epoxy resins, phenolic resins, unsaturated imide resins, cyanate resins, isocyanate resins, benzoxazine resins, oxetane resins, amino resins, unsaturated polyester resins, allyl resins, dicyclopentadiene resins, silicone resins, triazine resins, and melamine resins. Examples of inorganic fillers include silica, alumina, talc, mica, aluminum hydroxide, magnesium hydroxide, calcium carbonate, aluminum borate, and borosilicate glass. In each of the categories of thermosetting resins and inorganic fillers, one material such as listed above or two or more in combination can be used.

As for the form of the electrically insulating shaped article (A), an article made of a flexible material, an article made of a rigid material, and an article made of a rigid and flexible material can all be used, and the article may have a planar or three-dimensional solid shape. To be more specific, the electrically insulating shaped article (A) may be a commercially available material shaped into a three-dimensional solid shape or into a film, sheet, or plate or may be a material obtained by shaping a solution, melt, or liquid dispersion of a resin such as listed above into any shape. Alternatively, the electrically insulating shaped article (A) may be a substrate produced by forming a material of a resin such as listed above on metal or some other electrically conductive material.

For the form of the electrically insulating shaped article (A), a flat substrate, such as a film, sheet, or plate, may have a through hole, i.e., a hole running from one side to the other of the substrate. Alternatively, a multilayer substrate may have a structure in which its outer layer has a through hole, or the multilayer substrate as a whole may have a blind hole, a hole that reaches its inner-layer section. If the electrically insulating shaped article (A) has a through hole, the two sides of the through hole can be electrically coupled together through the below-described process according to the present invention for producing a printed wiring board. If the electrically insulating shaped article (A) is a multilayer substrate and has a structure that includes a blind hole as a hole reaching the inner-layer section, outer and inner electrically conductive layers can be electrically coupled together through the process according to the present invention for producing a printed wiring board.

If step 2 of the present invention, i.e., partial removal of an electrically conductive metal layer (M1), is carried out using electromagnetic waves, the electrically insulating shaped article (A) may contain a light-absorbing pigment or dye that absorbs the electromagnetic waves, such as graphite, carbon, a cyanine compound, a phthalocyanine compound, a dithiol metal complex, a naphthoquinone compound, a diimmonium compound, or an azo compound, as a light absorber, provided that it does not impair the heat resistance, mechanical strength, insulation characteristics, etc., of the electrically insulating shaped article (A) in the environment in which the finished shaped article is intended to be used. An appropriate substance can be selected from such pigments and dyes according to the wavelength of the electromagnetic waves used. One such pigment or dye or two or more in combination can be used. If the material for the electrically insulating shaped article (A) is a commercially available resin material, the resin material may be a colored resin material commercially available as a colored-grade material. The presence of a pigment or dye that absorbs the electromagnetic waves in the electrically insulating shaped article (A) is advantageous because it assists in removing the electrically conductive metal layer (M1) in step 2 of the present invention by absorbing the electromagnetic waves on the surface of the electrically insulating shaped article (A).

Step 1 of a method according to the present invention for producing a shaped article having a metal pattern is a step of forming an electrically conductive metal layer (M1) on the electrically insulating shaped article (A), the electrically conductive metal layer (M1) containing silver particles. This electrically conductive metal layer (M1) serves as a seed layer for plating when a patterned metal layer (PM2) is formed by electrolytic plating in step 3 described below. The electrically conductive metal layer (M1) is a metal layer containing silver particles, but may contain metal particles other than silver particles. Examples of metal particles other than silver particles include particles of metals such as gold, platinum, palladium, ruthenium, tin, copper, nickel, iron, cobalt, titanium, indium, and iridium. One or more types of such metal particles, if used, can be used together with the silver particles. In the present invention, silver particles are essential metal particles because, for example, they are relatively inexpensive, they have an electrical resistance sufficiently low for use as an electrically conductive metal layer in the electrolytic plating step described below, and their surface is not easily oxidized even when they are stored under atmospheric conditions.

If metal particles other than silver particles are contained, the percentage of the metal particles other than silver particles is not critical, provided they do not prevent the formation of the electrically conductive metal layer (M1) or cause a problem in the electrolytic plating in step 3 described below. Preferably, the percentage of such metal particles is 5 parts by mass or less, more preferably 2 parts by mass or less, per 100 parts by mass of silver particles. This helps make the removal of this layer by etching in step 4 described below even easier.

An example of a method for forming the electrically conductive metal layer (M1) is by coating the electrically insulating shaped article (A) with a liquid dispersion of silver particles. It is not critical how to coat with the liquid dispersion of silver particles as long as a good electrically conductive metal layer (M1) is formed; an appropriate method can be selected from various coating processes, for example according to the shape, size, and degree of rigidity or flexibility of the electrically insulating shaped article (A) used. Specific examples of coating processes include gravure coating, offset coating, flexo coating, pad printing, gravure offset coating, relief printing, double-sided relief printing, screen printing, microcontact printing, reverse printing, air-doctor coating, blade coating, air-knife coating, squeeze coating, impregnated coating, transfer-roll coating, kiss coating, cast coating, spray coating, inkjet printing, die coating, spin coating, bar coating, and dip coating.

Coating of both sides of a film-, sheet-, or plate-shaped electrically insulating article (A) with the liquid dispersion of silver particles can be by any method that gives a good electrically conductive metal layer (M1); an appropriate method can be selected from coating processes such as listed by way of example above. The electrically conductive metal layer (M1) in this case may be formed on both sides of the electrically insulating shaped article (A) simultaneously, or may be formed on one side of the electrically insulating shaped article (A) first and then on the other side. If the electrically insulating shaped article (A) is an article having a solid shape, processes such as spray coating, inkjet printing, and dip coating are suitable, although the manufacturer can select an appropriate method from coating processes such as listed by way of example above according to the size and shape of the article.

Before being coated with the liquid dispersion of silver particles, the electrically insulating shaped article (A) may undergo a surface treatment for the purposes of improved coating with the liquid dispersion of silver particles and improved adhesion of the metal pattern layer (PM2), formed in step 3, to the substrate. The surface treatment for the electrically insulating shaped article (A) can be of any kind unless the treated surface is so rough that it causes a problem in the formation of a fine-pitch pattern or the issue of signal transmission loss; an appropriate method can be selected from various treatments. Examples of surface treatments for such purposes include UV treatment, gas-phase ozonation, liquid-phase ozonation, corona treatment, and plasma treatment. One such surface treatment or two or more in combination can be used.

After the electrically insulating shaped article (A) is coated with the liquid dispersion of silver particles, the coating film is dried and sintered. This causes the solvent in the liquid dispersion of silver particles to evaporate, making the silver particles come close contact with each other and join together to form an electrically conductive metal layer (M1) on the electrically insulating shaped article (A). Here, drying is a process primarily of making solvent evaporate out of the liquid dispersion of silver particles, and sintering refers to a process primarily of causing silver particles to join together to develop electrical conductivity.

The drying and sintering may be simultaneous, or the coating film may be dried first and then sintered as necessary before use. The drying temperature and the duration of drying can be selected to be appropriate for the kind of solvent, described below, used in the liquid dispersion of silver particles, but preferably are in a range of 20°C to 250°C and in a range of 1 to 200 minutes for duration. As for sintering, an appropriate temperature and duration can be selected according to the desired electrical conductivity. Preferably, the temperature is in a range of 80°C to 350°C, and the duration is in a range of 1 to 200 minutes. To obtain a strongly adhering electrically conductive metal layer (M1) on the electrically insulating shaped article (A), it is more preferred that the sintering temperature be in a range of 80°C to 250°C.

The drying and sintering may involve blowing air or may not involve blowing air. The drying and sintering may be carried out in the air, may be carried out in an atmosphere purged with or under a stream of an inert gas, such as nitrogen or argon, or may be carried out in a vacuum.

If the electrically insulating shaped article (A) is a piece of film, sheet, or plate or an article having a three-dimensional solid shape, the drying and sintering can be by blowing air or carried out inside a drying oven, such as a temperature-controlled oven, as well as by air drying in the place where the coating is carried out. If the electrically insulating shaped article (A) is a roll material, such as a roll of film or a roll of sheet material, the drying and sintering can be by continuously moving the roll material inside an unheated or heated space placed after the coating step. Examples of heating methods for drying and sintering in this case include those involving an oven, a hot-air drying furnace, an infrared drying furnace, laser irradiation, microwaves, irradiation with light (a device that produces a flash of light), etc. One such heating method or two or more in combination can be used.

Preferably, the electrically conductive metal layer (M1) is one that contains 80% to 99.9% by mass silver particles and 0.1% to 20% by mass below-described dispersant component therein.

If step 2 of the present invention, i.e., partial removal of the electrically conductive metal layer (M1), is carried out using electromagnetic waves, the electrically conductive metal layer (M1) may contain a light-absorbing pigment or dye that absorbs the electromagnetic waves, such as graphite, carbon, a cyanine compound, a phthalocyanine compound, a dithiol metal complex, a naphthoquinone compound, a diimmonium compound, or an azo compound, as a light absorber to make the removal more efficient, provided that it does not prevent the formation of the electrically conductive metal layer (M1) or cause a problem in the electrolytic plating in step 3 described below and that the layer can certainly be removed by etching in step 4. An appropriate substance can be selected from such pigments and dyes according to the wavelength of the electromagnetic waves used. One such pigment or dye or two or more in combination can be used.

Preferably, the thickness of the electrically conductive metal layer (M1) is in a range of 50 to 500 nm. This helps make the electrical resistance of this layer lower and also helps make this layer a better seed layer for plating in step 3 described below. More preferably, the thickness of the electrically conductive metal layer (M1) is in a range of 50 to 200 nm. This helps make the removal of this layer in step 4, the step of removing this layer, even easier.

Preferably, the electrically conductive metal layer (M1) is an electrically highly conductive one in which silver particles are in close contact with one another and joined together. This helps make the electrolytic plating in step 3 described below easy. The electrically conductive metal layer in the pattern region (the region in which the pattern is to be formed) (PM1), formed in step 2 of the present invention, may have empty spaces between silver particles filled with the plating metal that will be used to form the patterned metal layer (PM2). Filling empty spaces between silver particles with a plating metal will be advantageous in the below-described step of removing, using an etchant, the electrically conductive metal layer in the no-pattern region (the region in which the pattern is not to be formed) (NPM1) in step 4. By virtue of the presence of the plating metal, the electrically conductive metal layer (PM1) under the patterned metal layer (PM2) is etched only to a limited extent. Undercuts are therefore less likely in the area in which the metal pattern has been formed.

The liquid dispersion of silver particles used to form the electrically conductive metal layer (M1) is a dispersion of silver particles in a solvent. The silver particles can be in any shape as long as they form a good electrically conductive metal layer (M1); silver particles in various shapes can be used, such as spherical, lenticular, polyhedral, flat-plate, rod-shaped, and wire-shaped ones. One type of silver particles in a single shape or two or more types in different shapes can be used.

Spherical or polyhedral silver particles are preferably ones having an average diameter of 1 to 20,000 nm. If the circuit pattern to be formed is a fine-pitch one, particles having an average diameter of 1 to 200 nm are more preferred, even more preferably those having an average diameter of 1 to 50 nm. This further improves the homogeneity of the electrically conductive metal layer (M1) and also helps make the removal of this layer using an etchant in step 4 described below even easier. Here, the "average diameter" in relation to particles of nanometer size is the volume-average diameter of the silver particles diluted in a good solvent for dispersion as measured by dynamic light scattering. This measurement can be done using Microtrac's "NANOTRAC UPA-150."

Lenticular, rod-shaped, wire-shaped, or similar silver particles are preferably ones having a minor axis of 1 to 200 nm, more preferably ones having a minor axis of 2 to 100 nm, even more preferably ones having a minor axis of 5 to 50 nm.

The silver particles are primarily silver, but may have part of the silver replaced with a different metal or may contain a non-silver metal component mixed therein unless it interferes with the electrolytic plating in step 3 by increasing the electrical resistance of the electrically conductive metal layer (A) or affects the removal of the electrically conductive metal layer (A) using an etchant in step 4.

An example of a replacing or mixed metal is one or more metal elements selected from the group consisting of gold, platinum, palladium, ruthenium, tin, copper, nickel, iron, cobalt, titanium, indium, and iridium.

Preferably, the percentage of the replacing or mixed metal in the silver particles is 5% by mass or less. It is more preferred that this percentage be 2% by mass or less in view of the electrical resistance of the electrically conductive metal layer (A) and for easier removal of the layer using an etchant.

The liquid dispersion of silver particles used to form the electrically conductive metal layer (M1) is a dispersion of silver particles in any of various solvents. The silver particles in the liquid dispersion may have a monodisperse size distribution, i.e., may be uniform in size, or may be a mixture of groups of particles having an average diameter in any of the ranges indicated above.

The solvent in the liquid dispersion of silver particles can be an aqueous medium or organic solvent. Examples of aqueous media include distilled water, deionized water, purified water, and ultrapure water. Examples of organic solvents include alcohol compounds, ether compounds, ester compounds, and ketone compounds.

Examples of alcohol or ether solvents include methanol, ethanol, n-propanol, isopropyl alcohol, n-butanol, isobutyl alcohol, sec-butanol, tert-butanol, heptanol, hexanol, octanol, nonanol, decanol, undecanol, dodecanol, tridecanol, tetradecanol, pentadecanol, stearyl alcohol, allyl alcohol, cyclohexanol, terpineol or terpene alcohol, dihydroterpineol, 2-ethyl-1,3-hexanediol, ethylene glycol, diethylene glycol, triethylene glycol, polyethylene glycol, propylene glycol, dipropylene glycol, 1,2-butanediol, 1,3-butanediol, 1,4-butanediol, 2,3-butanediol, glycerol, ethylene glycol monomethyl ether, ethylene glycol monoethyl ether, ethylene glycol monobutyl ether, diethylene glycol monoethyl ether, diethylene glycol monomethyl ether, diethylene glycol monobutyl ether, tetraethylene glycol monobutyl ether, propylene glycol monomethyl ether, dipropylene glycol monomethyl ether, tripropylene glycol monomethyl ether, propylene glycol monopropyl ether, dipropylene glycol monopropyl ether, propylene glycol monobutyl ether, dipropylene glycol monobutyl ether, and tripropylene glycol monobutyl ether.

Examples of ketone solvents include acetone, cyclohexanone, and methyl ethyl ketone. Examples of ester solvents include ethyl acetate, butyl acetate, 3-methoxybutyl acetate, and 3-methoxy-3-methyl-butyl acetate. Other organic solvents can also be used, such as toluene and other hydrocarbon solvents, in particular hydrocarbon solvents having eight or more carbon atoms.

Examples of hydrocarbon solvents having eight or more carbon atoms include octane, nonane, decane, dodecane, tridecane, tetradecane, cyclooctane, xylene, mesitylene, ethylbenzene, dodecylbenzene, tetralin, trimethylbenzene cyclohexane, and other nonpolar solvents, and such solvents can be used in combination with other solvents as necessary. Solvents such as mineral spirits and solvent naphtha, which are solvent mixtures, can also be used together with other solvents.

Any kind of solvent can be used as long as it allows the silver particles to disperse in a stable manner and form a good electrically conductive metal layer (M1) on the electrically insulating shaped article (A) or on the below-described primer layer (B) formed on the electrically insulating shaped article (A). One solvent or two or more in combination can be used.

The silver particle content of the liquid dispersion of silver particles is adjusted according to the selected coating process to give the liquid dispersion a viscosity that maximizes its coating suitability. Preferably, the silver particle content is in a range of 0.5% to 90% by mass, more preferably 1% to 60% by mass, even more preferably 2% to 10% by mass.

Preferably, the liquid dispersion of silver particles is one in which the silver particles remain dispersed in a stable manner, without aggregating or fusing together or precipitating, for a long period of time in the selected solvent, and preferably contains a dispersant for the silver particles to disperse in the solvent. For such purposes, dispersants having a functional group that becomes coordinated to the silver particles are preferred. Examples include dispersants having functional groups such as the carboxyl group, the amino group, the cyano group, the acetoacetyl group, phosphorus-containing groups, the thiol group, the thiocyanato group, and the glycinato group.

The dispersant can be a commercially available or independently synthesized dispersant having a low or high molecular weight. An appropriate dispersant can be selected according to the purpose, such as the solvent in which the silver particles are dispersed and the type of electrically insulating shaped article (A) to be coated with the liquid dispersion of silver particles. For example, compounds such as dodecanethiol, 1-octanethiol, triphenylphosphine, dodecylamine, polyethylene glycol, polyvinylpyrrolidone, polyethyleneimine, and polyvinylpyrrolidone; fatty acids, such as myristic acid, octanoic acid, and stearic acid; and carboxyl-bearing polycyclic hydrocarbon compounds, such as cholic acid, glycyrrhizic acid, and abietic acid, are suitable for use. If the electrically conductive metal layer (M1) is formed on the primer layer (B) described below, it is preferred to use a compound that has a reactive functional group [Y] that can bind with the reactive functional group [X] the resin with which the primer layer (B) is made. This leads to good adhesion between the two layers.

Examples of compounds that have a reactive functional group [Y] include those compounds having groups such as the amino group, the amide group, the alkylolamide group, the carboxyl group, the carboxylic anhydride group, the carbonyl group, the acetoacetyl group, the epoxy group, alicyclic epoxy groups, the oxetane ring, the vinyl group, the allyl group, the (meth)acryloyl group, the (blocked) isocyanate group, and the (alkoxy)silyl group and silsesquioxane compounds. It is particularly preferred that the reactive functional group [Y] be a group that contains a basic nitrogen atom because this helps further improve the adhesion between the primer layer (B) and the electrically conductive metal layer (M1). Examples of groups that contain a basic nitrogen atom include the imino, primary amino, and secondary amino groups.

There may be one or multiple groups that contain a basic nitrogen atom in each molecule of the dispersant. Preferably, the dispersant contains multiple basic nitrogen atoms because in this case part of the basic nitrogen-containing groups contributes to stable dispersion of the silver particles by interacting with the silver particles, and the rest contributes to improving adhesion to the electrically insulating shaped article (A). If the primer layer (B) described below is made with a resin having a reactive functional group [X], furthermore, the basic nitrogen-containing groups in the dispersant bind with this reactive functional group [X], thereby helping further improve the adhesion of the patterned metal layer (PM2) described below onto the electrically insulating shaped article (A).

Preferably, the dispersant is a polymeric dispersant. Polymeric dispersants are advantageous to the stability of and the ease of coating with the liquid dispersion of silver particles and helps form a strongly adhering electrically conductive metal layer (M1) on the electrically insulating shaped article (A). This polymeric dispersant is preferably, for example, a polyalkyleneimine, such as polyethyleneimine or polypropyleneimine, or an adduct of a polyalkyleneimine with a polyoxyalkylene.

The adduct of a polyalkyleneimine with a polyoxyalkylene may be a product of linear-chain binding of polyethyleneimine and a polyoxyalkylene or may be a product of grafting backbone polyethyleneimine with pendant polyoxyalkylenes.

Specific examples of adducts of a polyalkyleneimine with a polyoxyalkylene include block copolymers of polyethyleneimine and polyoxyethylene, a product of introducing the polyoxyethylene structure to backbone polyethyleneimine by adding ethylene oxide to part of the imino groups therein, and products of reaction between amino groups in a polyalkyleneimine, hydroxy groups in polyoxyethylene glycol, and epoxy groups in an epoxy resin.

Examples of commercially available polyalkyleneimines include "PAO 2006W," "PAO 306," "PAO 318," and "PAO 718," available as Nippon Shokubai Co., Ltd.'s "EPOMIN® PAO polymers."

Preferably, the number-average molecular weight of the polyalkyleneimine is in a range of 3,000 to 30,000.

Preferably, the amount of dispersant required to disperse the silver particles is in a range of 0.01 to 50 parts by mass per 100 parts by mass of the silver particles. Alternatively, it is preferred that the required amount of dispersant be in a range of 0.1 to 10 parts by mass per 100 parts by mass of the silver particles because this helps form a strongly adhering electrically conductive metal layer (M1) on the electrically insulating shaped article (A) or the primer layer (B) described below. More preferably, the required amount of dispersant is in a range of 0.1 to 5 parts by mass. This additionally helps improve the electrical conductivity of the electrically conductive metal layer (M1).

It is not critical how to produce the liquid dispersion of silver particles; various processes can be used to produce it. For example, silver particles produced using a gas-phase process, such as low-vacuum evaporation, may be dispersed in a solvent, or a silver compound may be reduced in a liquid phase to give a liquid dispersion of silver particles directly. Optionally, the solvent makeup of the liquid dispersion, whether prepared by a gas-phase or liquid-phase process, can be changed before coating by solvent exchange and/or adding an extra solvent as needed. Of the gas-phase and liquid-phase processes, liquid-phase processes are particularly suitable for use because of the stability of the resulting liquid dispersion and the simplicity and convenience of the production process. An example of a liquid-phase process is to produce the liquid dispersion by reducing silver ions in the presence of a polymeric dispersant as described above.

The liquid dispersion of silver particles may further contain surfactants, leveling agents, viscosity modifiers, film-forming agents, defoamers, preservatives, and other organic compounds as necessary.

Examples of surfactants include nonionic surfactants, such as polyoxyethylene nonyl phenyl ether, polyoxyethylene lauryl ether, polyoxyethylene styryl phenyl ether, polyoxyethylene sorbitol tetraoleate, and polyoxyethylene-polyoxypropylene copolymers; anionic surfactants, such as sodium oleate and other salts of fatty acids, alkyl sulfates, alkylbenzene sulfonates, alkyl sulfosuccinates, naphthalene sulfonate, polyoxyethylene alkyl sulfates, sodium alkane sulfonates, and sodium alkyl diphenyl ether sulfonates; and cationic surfactants, such as alkylamine salts, alkyltrimethylammonium salts, and alkyldimethylbenzylammonium salts.

For leveling agents, commonly used leveling agents can be used. Examples include silicone compounds, acetylene diol compounds, fluorine compounds.

For viscosity modifiers, commonly used thickening agents can be used. Examples include acrylic polymers and synthetic rubber latex, which thicken the system when the pH is adjusted into the alkaline range, and urethane resins, hydroxyethyl cellulose, carboxymethyl cellulose, methyl cellulose, polyvinyl alcohol, hydrated castor oil, amide waxes, polyethylene oxide, metal soaps, and dibenzylidene sorbitol, which thicken the system through molecular association.

For film-forming agents, commonly used film-forming agents can be used. Examples include sodium dioctyl sulfosuccinate and other anionic surfactants, sorbitan monooleate and other hydrophobic nonionic surfactants, polyether-modified siloxanes, and silicone oils.

For defoamers, commonly used defoamers can be used. Examples include silicone defoamers, nonionic surfactants, polyethers, higher alcohols, and polymeric surfactants.

For preservatives, commonly used preservatives can be used. Examples include isothiazolinone preservatives, triazine preservatives, imidazole preservatives, pyridine preservatives, azole preservatives, and pyrithione preservatives.

The present invention has a more preferred embodiment, which is a method in which before the formation of the electrically conductive metal layer (M1) containing silver particles on the electrically insulating shaped article (A), a primer layer (B) is formed on the electrically insulating shaped article (A), and then the electrically conductive metal layer (M1) containing silver particles is formed on this layer (step 1'). This method in which a primer layer (B) is formed is advantageous in that it helps further improve the adhesion of the metal pattern layer (PM2) to the electrically insulating shaped article (A).

The primer layer (B) can be formed by coating part or all of the surface of the electrically insulating shaped article (A) with a primer and removing the solvent, such as an aqueous medium or organic solvent, contained in the primer. Here, the primer is used to improve the adhesion of the metal pattern layer (PM2) to the electrically insulating shaped article (A) and is a liquid composition obtained by dissolving or dispersing any of resins as described below in a solvent.

It is not critical how to coat the electrically insulating shaped article (A) with the primer as long as a good primer layer (B) can be formed; an appropriate method can be selected from various coating processes, for example according to the shape, size, and degree of rigidity or flexibility of the electrically insulating shaped article (A) used. Specific examples of coating processes include gravure coating, offset coating, flexo coating, pad printing, gravure offset coating, relief printing, double-sided relief printing, screen printing, microcontact printing, reverse printing, air-doctor coating, blade coating, air-knife coating, squeeze coating, impregnated coating, transfer-roll coating, kiss coating, cast coating, spray coating, inkjet printing, die coating, spin coating, bar coating, and dip coating.

Coating of both sides of a film-, sheet-, or plate-shaped electrically insulating shaped article (A) with the primer can be by any method that gives a good primer layer (B); an appropriate method can be selected from such coating processes as listed by way of example above. The primer layer (B) in this case may be formed on both sides of the electrically insulating shaped article (A) simultaneously or may be formed on one side of the electrically insulating shaped article (A) first and then on the other side. If the electrically insulating shaped article (A) is an article having a solid shape, processes such as spray coating, inkjet printing, and dip coating are suitable, although the manufacturer can select an appropriate method from such coating processes as listed by way of example above according to the size and shape of the article.

Before being coated with the primer (step 1'), the electrically insulating shaped article (A) may undergo a surface treatment for the purposes of improved coating with the primer and improved adhesion of the metal pattern layer (PM2) to the substrate. The surface treatments for the electrically insulating shaped article (A) that can be used are the same as in the formation of the electrically conductive metal layer (M1) containing silver particles on the electrically insulating shaped article (A) described above.

After the surface of the electrically insulating shaped article (A) is coated with the primer, the solvent in the coating layer is removed to form the primer layer (B). An example of an ordinary way to do this is to evaporate the solvent by drying the coating layer in a drying oven. The drying temperature can be set to any temperature at which the solvent evaporates and the electrically insulating shaped article (A) suffers no adverse effects, and either drying at room temperature or drying by heating works. Specifically, the drying temperature is preferably in a range of 20°C to 350°C, more preferably 60°C to 300°C. The duration of drying is preferably in a range of 1 to 200 minutes, more preferably 1 to 60 minutes.

The drying may involve blowing air or may not involve blowing air. The drying may be carried out in the air, may be carried out in an atmosphere purged with or under a stream of an inert gas, such as nitrogen or argon, or may be carried out in a vacuum.

If the electrically insulating shaped article (A) is a piece of film, sheet, or plate or an article having a three-dimensional solid shape, the drying can be by blowing air or carried out inside a drying oven, such as a temperature-controlled oven, as well as by air drying in the place where the coating is carried out. If the electrically insulating shaped article (A) is a roll of film or a roll of sheet material, the drying can be by continuously moving the roll material inside an unheated or heated space placed after the coating step.

The thickness of the primer layer (B) can be selected to be appropriate for the specifications and purpose of use of the article having a metal pattern produced using the present invention. Preferably, the thickness of the primer layer (B) is in a range of 10 nm to 30 **µ**m, more preferably 10 nm to 1 **µ**m, even more preferably 10 nm to 500 nm. This helps further improve the adhesion between the electrically insulating shaped article (A) and the patterned metal layer (PM2).

If the silver particles are dispersed using a dispersant having a reactive functional group [Y], it is preferred that the primer layer (B) be formed by a resin that has a reactive functional group [X] that reacts with the reactive functional group [Y]. Examples of reactive functional groups [X] include the amino group, the amide group, the alkylolamide group, the carboxyl group, the carboxylic anhydride group, the carbonyl group, the acetoacetyl group, the epoxy group, alicyclic epoxy groups, the oxetane ring, the vinyl group, the allyl group, the (meth)acryloyl group, the (blocked) isocyanate group, and the (alkoxy)silyl group. Silsesquioxane compounds can also be used to form the primer layer (B).

In particular, if the reactive functional group [Y] in the dispersant is a group that contains a basic nitrogen atom, it is preferred that the resin forming the primer layer (B) be one that has a carboxyl, carbonyl, acetoacetyl, epoxy, alicyclic epoxy, alkylolamide, isocyanate, vinyl, (meth)acryloyl, or allyl group as a reactive functional group [X]. This helps further improve the adhesion of the metal pattern layer (PM2) on the electrically insulating shaped article (A).

Examples of resins that can be used to form the primer layer (B) include urethane resins, acrylic resins, core-shell composite resins formed by a shell urethane resin and a core acrylic resin, epoxy resins, imide resins, amide resins, melamine resins, phenolic resins, urea formaldehyde resins, blocked isocyanates, which are obtained by reacting a polyisocyanate with phenol or some other blocking agent polyvinyl alcohol, and polyvinyl pyrrolidone. A core-shell composite resin formed by a shell urethane resin and a core acrylic resin can be obtained by, for example, polymerizing an acrylic monomer in the presence of a urethane resin. One such resin or two or more in combination can be used.

Of such resins that can be used to form the primer layer (B), resins that produce a reducing compound upon heating are particularly preferred. They help further improve the adhesion of the metal pattern layer (PM2) onto the electrically insulating shaped article (A). Examples of reducing compounds include phenolic compounds, aromatic amine compounds, sulfur compounds, phosphoric acid compounds, and aldehyde compounds. Of these reducing compounds, phenolic compounds and aldehyde compounds are particularly preferred.

A primer made with a resin that produces a reducing compound upon heating yields a reducing compound, such as formaldehyde or phenol, during a drying and heating step carried out in the formation of the primer layer (B). Specific examples of resins that produce a reducing compound upon heating include resins that produce formaldehyde upon heating, such as resins obtained by polymerizing a monomer containing an N-alkylol(meth)acrylamide, core-shell composite resins formed by a shell urethane resin and a core resin obtained by polymerizing a monomer containing an N-alkylol(meth)acrylamide, urea-formaldehyde-methanol condensates, urea-melamine-formaldehyde-methanol condensates, poly N-alkoxymethylol(meth)acrylamides, formaldehyde adducts of poly(meth)acrylamide, and melamine resins; and resins that produce a phenolic compound upon heating, such as phenolic resins and phenol-blocked isocyanates. Of these resins, core-shell composite resins formed by a shell urethane resin and a core resin obtained by polymerizing a monomer containing an N-alkylol(meth)acrylamide, melamine resins, and phenol-blocked isocyanates are particularly preferred for improved adhesion.

It should be noted that in the present invention, "(meth)acrylamide" refers to one or both of "methacrylamide" and "acrylamide." "(Meth)acrylic acid" refers to one or both of "methacrylic acid" and "acrylic acid." "(Meth)acrylate" refers to one or both of "methacrylate" and "acrylate."

A resin that produces a reducing compound upon heating can be obtained by polymerizing, for example by radical polymerization, anionic polymerization, or cationic polymerization, a monomer having a functional group that produces a reducing compound upon heating.

Examples of monomers having a functional group that produces a reducing compound upon heating include N-alkylol vinyl monomers, specifically N-methylol(meth)acrylamide, N-methoxymethyl(meth)acrylamide, N-ethoxymethyl(meth)acrylamide, N-propoxymethyl(meth)acrylamide, N-isopropoxymethyl(meth)acrylamide, N-n-butoxymethyl(meth)acrylamide, N-isobutoxymethyl(meth)acrylamide, N-pentoxymethyl(meth)acrylamide, N-ethanol (meth)acrylamide, and N-propanol (meth)acrylamide.

In preparing this resin that produces a reducing compound upon heating, the monomer having a functional group that produces a reducing compound upon heating, for example, can be copolymerized with other monomers, such as an alkyl (meth)acrylate.

If a blocked isocyanate is used as a resin for forming the primer layer (B), it forms the primer layer (B) by reacting within itself, i.e., through reaction between its isocyanate groups, forming uretdione bonds or through binding between its isocyanate groups and a functional group of another component. The bonds formed in this process may be formed before the coating with the liquid dispersion of silver particles or may not be formed before the coating with the liquid dispersion of silver particles but be formed by heating after the coating with the liquid dispersion of silver particles.

Examples of blocked isocyanates include those having a functional group formed by the blocking of their isocyanate groups by a blocking agent.

Preferably, the blocked isocyanate is one having such a functional group in a range of 350 to 600 g/mol per mol of the blocked isocyanate.

Preferably, the blocked isocyanate is one that has one to ten such functional groups, more preferably two to five, per molecule for improved adhesion.

Preferably, the number-average molecular weight of the blocked isocyanate is in a range of 1,500 to 5,000, more preferably 1,500 to 3,000, for improved adhesion.

Furthermore, for further improved adhesion, it is preferred that the blocked isocyanate be one that has an aromatic ring. Examples of aromatic rings include the phenyl group and the naphthyl group.

A blocked isocyanate can be produced by reacting part or all of isocyanate groups of an isocyanate compound with a blocking agent.

Examples of isocyanate compounds that can be used as raw materials for a blocked isocyanate include polyisocyanate compounds having an aromatic ring, such as 4,4'-diphenylmethane diisocyanate, 2,4'-diphenylmethane diisocyanate, carbodiimide-modified diphenylmethane diisocyanate, crude diphenylmethane diisocyanate, phenylene diisocyanate, tolylene diisocyanate, and naphthalene diisocyanate; and aliphatic polyisocyanate compounds or polyisocyanate compounds having an alicyclic structure, such as hexamethylene diisocyanate, lysine diisocyanate, cyclohexane diisocyanate, isophorone diisocyanate, dicyclohexylmethane diisocyanate, xylylene diisocyanate, and tetramethylxylylene diisocyanate. Also included are biurets, isocyanurates, and adducts of such polyisocyanate compounds.

Furthermore, products of reacting any of the polyisocyanate compounds listed by way of example above with, for example, a compound having a hydroxy or amino group are also examples of raw-material isocyanate compounds.

If an aromatic ring is introduced into the blocked isocyanate, it is preferred to use a polyisocyanate compound having an aromatic ring. Of polyisocyanate compounds having an aromatic ring, 4,4'-diphenylmethane diisocyanate, tolylene diisocyanate, the isocyanurate of 4,4'-diphenylmethane diisocyanate, and the isocyanurate of tolylene diisocyanate are particularly preferred.

Examples of blocking agents used to produce a blocked isocyanate include phenolic compounds, such as phenol and cresol; lactam compounds, such as **ε**-caprolactam, **δ-**valerolactam, and γ-butyrolactam; oxime compounds, such as formamide oxime, acetaldoxime, acetone oxime, methyl ethyl ketoxime, methyl isobutyl ketoxime, and cyclohexanone oxime; and 2-hydroxypyridine, butyl cellosolve, propylene glycol monomethyl ether, benzyl alcohol, methanol, ethanol, n-butanol, isobutanol, dimethyl malonate, diethyl malonate, methyl acetoacetate, ethyl acetoacetate, acetylacetone, butyl mercaptan, dodecyl mercaptan, acetanilide, acetamide, succinimide, maleimide, imidazole, 2-methylimidazole, urea, thiourea, ethyleneurea, diphenylaniline, aniline, carbazole, ethyleneimine, polyethyleneimine, 1H-pyrazole, 3-methylpyrazole, and 3,5-dimethylpyrazole. Of these, blocking agents that dissociate and produce isocyanate groups upon heating in a range of 70°C to 200°C are particularly preferred, more preferably those that produce isocyanate groups that dissociate upon heating in a range of 110°C to 180°C. Specifically, phenolic compounds, lactam compounds, and oxime compounds are preferred. Phenolic compounds, in particular, are more preferred than the others because they ensure that the blocking agent turns into a reducing compound when eliminated by heating.

The production of the blocked isocyanate can be, for example, by mixing an isocyanate compound prepared beforehand with a blocking agent and allowing them to react together or by mixing raw materials for the production of an isocyanate compound with a blocking agent and allowing them to react together.

In more specific terms, the blocked isocyanate can be produced by reacting a polyisocyanate compound with a compound having a hydroxy or amino group to give an isocyanate compound having a terminal isocyanate group, then mixing the isocyanate compound with a blocking agent, and allowing them to react together.

Preferably, the percentage of the blocked isocyanate obtained in this way to the resin(s) forming the primer layer (B) is in a range of 50% to 100% by mass, more preferably 70% to 100% by mass.

Examples of melamine resins include mono- or polymethylol melamine produced by adding 1 to 6 moles of formaldehyde to each mole of melamine; etherified derivatives of (poly)methylol melamine (to any degree of etherification), such as trimethoxymethylol melamine, tributoxymethylol melamine, and hexamethoxymethylol melamine; and urea-melamine-formaldehyde-methanol condensates.

Instead of using a resin that produces a reducing agent upon heating as described above, a reducing compound may be added to a resin. Examples of reducing compounds added in this case include phenolic antioxidants, aromatic-amine antioxidants, sulfur antioxidants, phosphoric-acid antioxidants, vitamin C, vitamin E, sodium ethylenediaminetetraacetate, sulfites, hypophosphoric acid, hypophosphites, hydrazine, formaldehyde, sodium borohydride, dimethylamine borane, and phenol.

In the present invention, using a resin that produces a reducing compound upon heating is preferred over adding a reducing compound to a resin. The latter can affect electrical characteristics because it eventually leaves low-molecular-weight components and ionic compounds.

Preferably, the percentage of the resin in the primer used to form the primer layer (B) is 1% to 70% by mass, more preferably 1% to 20% by mass, for easier coating and better film formation.

Examples of solvents that can be used in the primer include organic solvents and aqueous media. Examples of organic solvents include toluene, ethyl acetate, methyl ethyl ketone, and cyclohexanone. Examples of aqueous media include water, organic solvents miscible with water, and mixtures thereof.

Examples of organic solvents miscible with water include alcohol solvents, such as methanol, ethanol, n-propanol, isopropanol, ethyl carbitol, ethyl cellosolve, and butyl cellosolve; ketone solvents, such as acetone and methyl ethyl ketone; alkylene glycol solvents, such as ethylene glycol, diethylene glycol, and propylene glycol; polyalkylene glycol solvents, such as polyethylene glycol, polypropylene glycol, and polytetramethylene glycol; and lactam solvents, such as N-methyl-2-pyrrolidone.

Optionally, the resin used to form the primer layer (B) may have functional groups that contribute to crosslinking reaction, such as alkoxysilyl, silanol, hydroxy, or amino groups. The crosslink structure formed using these functional groups may have already been formed as early as before the subsequent step of forming the electrically conductive metal layer (M1) containing silver particles, or may be formed at any point after the step of forming the electrically conductive metal layer (M1) containing silver particles. If the crosslink structure is formed at any point after the step of forming the electrically conductive metal layer (M1) containing silver particles, the crosslink structure may have been formed in the primer layer (B) before the formation of the metal pattern layer (PM2) or may be formed in the primer layer (B), for example by aging, after the formation of the metal pattern layer (PM2).

Optionally, the primer layer (B) may be used with known additives as necessary, from crosslinking agents to pH-modifying agents, agents that help form a coating, leveling agents, thickening agents, water repellents, and defoamers.

Examples of crosslinking agents include metal chelate compounds, polyamine compounds, aziridine compounds, metal salt compounds, and isocyanate compounds. Examples include thermal crosslinking agents that react and form a crosslink structure at relatively low temperatures of approximately 25°C to 100°C, thermal crosslinking agents that react and form a crosslink structure at relatively high temperatures of 100°C or above, such as melamine compounds, epoxy compounds, oxazoline compounds, carbodiimide compounds, and blocked isocyanate compounds, and photocrosslinking agents.

The amount of crosslinking agent used varies by type, but preferably is in a range of 0.01 to 60 parts by mass in a total of 100 parts by mass of resins in the primer for improved adhesion of the patterned metal layer (PM2) onto the electrically insulating shaped article (A). More preferably, the amount of crosslinking agent used is 0.1 to 10 parts by mass, even more preferably 0.1 to 5 parts by mass.

If a crosslinking agent is used, the crosslink structure may have been formed as early as before the subsequent step of forming the electrically conductive metal layer (M1) containing silver particles, or may be formed at any point after the step of forming the electrically conductive metal layer (M1) containing silver particles. If the crosslink structure is formed at any point after the step of forming the electrically conductive metal layer (M1) containing silver particles, the crosslink structure may be formed in the primer layer (B) before the formation of the patterned metal layer (PM2) or may be formed in the primer layer (B), for example by aging, after the formation of the patterned metal layer (PM2).

The formation of the electrically conductive metal layer (M1) containing silver particles on the primer layer (B) in step 1' of the present invention is the same as the formation of the electrically conductive metal layer (M1) containing silver particles on the electrically insulating shaped article (A).

Like the electrically insulating shaped article (A), the primer layer (B) may undergo a surface treatment for the purposes of improved coating with the liquid dispersion of silver particles and improved adhesion of the metal pattern layer (PM2) to the electrically insulating shaped article (A) before being coated with the liquid dispersion of silver particles.

In step 2 of the present invention, part of the electrically conductive metal layer (M1) is removed to separate this layer into an electrically conductive metal layer in the pattern region (PM1) and an electrically conductive metal layer in the no-pattern region (NPM1). The pattern region is a region in which the pattern is to be formed, whereas the no-pattern region is a region in which the pattern is not to be formed. To separate the electrically conductive metal layer (M1) into that in the pattern region (PM1) and that in the no-pattern region (NPM1), the manufacturer simply removes the electrically conductive metal layer (M1) in the boundary area, i.e., a certain area between the region in which the intended metal pattern is to be formed (PM1) and the region in which the metal pattern is not to be formed (NPM1). The removal of the electrically conductive metal layer (M1) in the boundary area can be achieved by, for example, mechanically milling the electrically conductive metal layer (M1) or removing the layer by irradiating it with electromagnetic waves. Mechanical milling of the electrically conductive metal layer (M1) can be carried out using, for example, ePRONICS's PCB prototyping machine. Examples of ways of removal by irradiation with electromagnetic waves include the use of X-rays, a pulsed flashlamp, a laser, etc.

Of these ways to remove the electrically conductive metal layer (M1) in the boundary area, removal by irradiation with electromagnetic waves is preferred owing to the high resolution of the formed pattern it achieves and its ease of application to articles in various shapes. Of methods based on irradiation with electromagnetic waves, it is particularly preferred to use a laser by virtue of its high energy that allows for easy removal of the electrically conductive metal layer (M1) and the simplicity and convenience of its industrial use.

The laser used can be a known and commonly used infrared, visible, or ultraviolet laser and may be a continuous-wave or pulsed laser. Examples of infrared lasers include carbon dioxide (CO₂) lasers, Nd:YAG lasers, Er:YAG lasers, Yb:YAG lasers, Tm:YAG lasers, Nd:YLF lasers, Nd:glass lasers, Nd:YVO₄ lasers, Cr forsterite lasers, titanium sapphire lasers, and alexandrite lasers. Examples of visible lasers include glass lasers, ruby lasers, copper vapor lasers, dye lasers, and the second harmonics of infrared lasers. Examples of ultraviolet lasers include nitrogen lasers, excimer lasers, and the third and fourth harmonics of infrared lasers. A laser may be selected from semiconductor lasers of different wavelengths and harmonics of semiconductor lasers according to the purpose.

Preferably, the laser used to remove the electrically conductive metal layer (M1) in the boundary area has a scanning system with which its laser light emitter can be moved at high speeds on the electrically conductive metal layer (M1), for example using a galvano scanner or fiber optics, so that the layer can be irradiated with laser light in accordance with the desired pattern shape. Such a scanning system may be created by combining a laser oscillator with a galvano scanner or fiber optics or may be a commercially available laser prototyping machine, laser marker, or similar device.

Of these various lasers, carbon dioxide (CO₂) lasers, Nd:YAG lasers, Er:YAG lasers, Yb:YAG lasers, Tm:YAG lasers, Nd:YLF lasers, Nd: glass lasers, Nd:YVO₄ lasers, and semiconductor lasers are particularly suitable for industrial use. Systems incorporating these lasers are commercially available as laser prototyping machines or laser markers.

In step 2, the boundary between the pattern and no-pattern regions of the electrically conductive metal layer (M1) is irradiated with laser light while the laser light is moved in accordance with (passed over) the desired pattern. As a result, the electrically conductive metal layer (M1) is removed and is separated into that in the pattern region (PM1) and that in the no-pattern region (NPM1). When the electrically conductive metal layer (M1) is removed, the surface of the electrically insulating shaped article (A) or of the primer layer (B) or the surfaces of the primer layer (B) and the electrically insulating shaped article (A) under the electrically conductive metal layer (M1) irradiated with the laser may be removed along with the electrically conductive metal layer (M1).

In step 3 of the present invention, a patterned metal layer (PM2), which is a layer of plating metal, is formed on the electrically conductive metal layer in the pattern region (PM1) formed as described above. This is by electrolytic plating with the electrically conductive metal layer in the pattern region (PM1) serving as the cathode. No electric current is run through the electrically conductive metal layer in the no-pattern region (NPM1); therefore, the no-pattern region does not thicken through the electrolytic plating.

Examples of metals that can be used to form the patterned metal layer (PM2) include copper, nickel, chromium, zinc, tin, gold, silver, rhodium, palladium, and platinum. If the metal pattern to be formed is a conductor-circuit pattern, copper is particularly preferred among these metals because of its low price and low electrical resistance; the patterned metal layer (PM2) is formed preferably by electrolytic copper plating. The electrolytic copper plating can be by any known and commonly used method, but preferably is by copper sulfate plating, i.e., plating using a copper sulfate bath.

To form the patterned metal layer (PM2), one plating metal or two or more in combination can be used. For example, if the metal pattern to be formed is a decorative pattern, copper plating is made under the outermost nickel-chromium plating to relax the stress in the plating metals. The plating process in this case may be electrolytic nickel plating on the electrically conductive metal layer in the pattern region (PM1) first, then electrolytic copper plating, and subsequently electrolytic nickel and electrolytic chromium plating, or may be electrolytic copper plating on the electrically conductive metal layer in the pattern region (PM1) first and then electrolytic nickel and electrolytic chromium plating.

In the method according to the present invention for producing a shaped article having a metal pattern, annealing may be performed after the plating to relax the stress in and improve the strength of the adhesion of the plating film. The annealing may be carried out before the etching in step 4 described below, may be carried out after the etching, or may be carried out before and after the etching.

An appropriate annealing temperature can be selected within the temperature range of 40°C to 300°C according to the thermal resistance of the substrate used and the intended purpose of use. Preferably, the annealing temperature is in a range of 40°C to 250°C, more preferably 40°C to 200°C in order that oxidative degradation of the plating film will be reduced. As for the duration of annealing, 10 minutes to 10 days is good if the temperature is in a range of 40°C to 200°C, and approximately 5 minutes to 10 hours is good for annealing at a temperature above 200°C. If the plating film is annealed, an antirust may optionally be applied to the surface of the plating film before that.

In step 4 of the present invention, the electrically conductive metal layer in the no-pattern region (NPM1) is removed using an etchant. Preferably, the etchant is one that selectively etches the electrically conductive metal layer (M1) only and does not etch the metal pattern layer (M2). Since the electrically conductive metal layer (M1) contains silver particles, etchants that quickly dissolve silver are preferred. Examples of compositions of such etchants include dilute nitric acid, a mixture of a carboxylic acid and hydrogen peroxide, a mixture of aqueous ammonia and hydrogen peroxide, hydrochloric acid, a mixture of hydrochloric acid and nitric acid, a mixture of sulfuric acid and nitric acid, a mixture of sulfuric acid, nitric acid, and an organic acid (e.g., acetic acid), and a mixture of phosphoric acid, nitric acid, and an organic acid (e.g., acetic acid).

If the metal forming the metal pattern layer (PM2) is copper, the etchant is preferably one with which only silver is removed efficiently and copper to a minimum extent when the electrically conductive metal layer in the no-pattern region (NPM1) is removed in step 4 of the present invention. An example of such an etchant is a mixture of a carboxylic acid and hydrogen peroxide.

Examples of carboxylic acids include acetic acid, formic acid, propionic acid, butyric acid, valeric acid, caproic acid, enanthic acid, caprylic acid, pelargonic acid, capric acid, lauric acid, myristic acid, palmitic acid, margaric acid, stearic acid, oleic acid, linoleic acid, linolenic acid, arachidonic acid, eicosapentaenoic acid, docosahexaenoic acid, oxalic acid, malonic acid, succinic acid, benzoic acid, salicylic acid, phthalic acid, isophthalic acid, terephthalic acid, gallic acid, mellitic acid, cinnamic acid, pyruvic acid, lactic acid, malic acid, citric acid, fumaric acid, maleic acid, aconitic acid, glutaric acid, adipic acid and amino acids. One such carboxylic acid or two or more in combination can be used. Of these carboxylic acids, it is particularly preferred to use acetic acid primarily. Acetic acid can be easily made into an etchant and is easy to handle.

A mixture of a carboxylic acid and hydrogen peroxide used as an etchant, the inventors believe, produces a peroxycarboxylic acid through the reaction of the hydrogen peroxide with the carboxylic acid. The resulting peroxycarboxylic acid presumably dissolves the silver forming the electrically conductive metal layer (M1) preferentially, while dissolving the copper forming the patterned metal layer (PM2) only to a limited extent.

Preferably, the proportions between the carboxylic acid and hydrogen peroxide in the mixture are in a range of 2 to 100 moles, more preferably 2 to 50 moles, of hydrogen peroxide per mole of the carboxylic acid. This helps limit the dissolution of the metal pattern layer (PM2).

Preferably, the mixture of a carboxylic acid and hydrogen peroxide is an aqueous solution, diluted with water. The percentage of the mixture of a carboxylic acid and hydrogen peroxide in the aqueous solution is preferably in a range of 2% to 65% by mass, more preferably 2% to 30% by mass. This helps reduce the effect of increased temperature of the etchant.

As for the water used to dilute the mixture, it is preferred to use water from which ionic substances and impurities have been removed, such as deionized water, purified water, or ultrapure water.

The etchant may further contain a protective agent added to protect the metal pattern layer (PM2) and thereby to limit the dissolution thereof. If the metal pattern layer (PM2) is an electrolytic copper plating layer, it is preferred to use an azole compound as a protective agent.

Examples of azole compounds include imidazoles, pyrazoles, triazoles, tetrazoles, oxazoles, thiazoles, selenazoles, oxadiazoles, thiadiazoles, oxatriazoles, and thiatriazoles.

Specific examples of azole compounds include 2-methylbenzimidazole, aminotriazole, 1,2,3-benzotriazole, 4-aminobenzotriazole, 1-bisaminomethylbenzotriazole, aminotetrazole, phenyltetrazole, 2-phenylthiazole, and benzothiazole. One such azole compound or two or more in combination can be used.

Preferably, the concentration of the azole compound in the etchant is in a range of 0.001% to 2% by mass, more preferably 0.01% to 0.2% by mass.

If the metal pattern layer (PM2) is an electrolytic copper plating layer, furthermore, it is preferred that the etchant contain a polyalkylene glycol added as a protective agent. This helps limit the dissolution of the electrolytic copper plating layer.

Examples of polyalkylene glycols include water-soluble polymers, such as polyethylene glycol, polypropylene glycol, and polyoxyethylene polyoxypropylene block copolymers. Of these, polyethylene glycol is particularly preferred. Preferably, the number-average molecular weight of the polyalkylene glycol is in a range of 200 to 20,000.

The concentration of the polyalkylene glycol in the etchant is preferably in a range of 0.001% to 2% by mass, more preferably 0.01% to 1% by mass.

The etchant may optionally contain a sodium salt, potassium salt, or ammonium salt of an organic acid or a similar additive mixed in to reduce fluctuations in pH.

The removal of the electrically conductive metal layer in the no-pattern region (NPM1) in step 4 of the present invention can be achieved either by immersing the substrate, with the metal pattern layer (PM2) thickened through electrolytic plating thereon, into the etchant or by spraying the substrate with the etchant, for example using a sprayer.

If the patterned metal layer (PM2) is formed by multiple metals as mentioned above, the electrically conductive metal layer in the no-pattern region (NPM1) may be removed using an etchant after electrolytic plating, and then the workpiece may be electrolytically plated with another metal. Alternatively, the electrically conductive metal layer in the no-pattern region (NPM1) may be removed using an etchant after electrolytic plating with the multiple metals.

If an etch system is used to remove the electrically conductive metal layer in the no-pattern region (NPM1), the etchant may be, for example, prepared to its predetermined composition with all of its ingredients first and then supplied to the etch system. Alternatively, each ingredient of the etchant may be supplied to the etch system first, and then the etchant may be prepared to its predetermined composition inside the system, by mixing the components together there.

Preferably, the etchant is used in a temperature range of 10°C to 35°C. In particular, an etchant that contains hydrogen peroxide is used preferably in a temperature range of 30°C or below. This helps limit the decomposition of the hydrogen peroxide.

In step 4 of the present invention, a cleaning operation other than washing in water may be carried out after the removal of the electrically conductive metal layer in the no-pattern region (NPM1) using an etchant to prevent silver components dissolved in the etchant from adhering to or remaining on the printed wiring board. Preferably, the cleaning operation is with the use of a cleaning solution that dissolves silver oxide, silver sulfide, and silver chloride but dissolves silver only sparingly. Specifically, it is preferred to use an aqueous solution containing a thiosulfate or tris(3-hydroxyalkyl)phosphine or an aqueous solution containing a mercaptocarboxylic acid or its salt as a cleaning chemical.

Examples of thiosulfates include ammonium thiosulfate, sodium thiosulfate, and potassium thiosulfate. Examples of tris(3-hydroxyalkyl)phosphines include tris(3-hydroxymethyl)phosphine, tris(3-hydroxyethyl)phosphine, and tris(3-hydroxypropyl)phosphine. In each of the categories of thiosulfates and tris(3-hydroxyalkyl)phosphines, one compound such as listed above or two or more in combination can be used.

If an aqueous solution containing a thiosulfate is used, an appropriate concentration can be selected for it, for example according to the process time and the characteristics of the cleaning system used. Preferably, the concentration is in a range of 0.1% to 40% by mass, more preferably 1% to 30% by mass in view of cleaning efficiency and the stability of the chemical in continuous use.

If an aqueous solution containing a tris(3-hydroxyalkyl)phosphine is used, an appropriate concentration can be selected for it, for example according to the process time and the characteristics of the cleaning system used. Preferably, the concentration is in a range of 0.1% to 50% by mass, more preferably 1% to 40% by mass in view of cleaning efficiency and the stability of the chemical in continuous use.

Examples of mercaptocarboxylic acids include thioglycolic acid, 2-mercaptopropionic acid, 3-mercaptopropionic acid, thiomalic acid, cysteine, and N-acetylcysteine. Examples of salts of mercaptocarboxylic acids include alkali metal salts, ammonium salts, and amine salts.

If an aqueous solution of a mercaptocarboxylic acid or its salt is used, the concentration is preferably in a range of 0.1% to 20% by mass. More preferably, the concentration is in a range of 0.5% to 15% by mass in view of cleaning efficiency and the process cost involved in large-scale treatment.

This cleaning operation can be carried out by, for example, immersing the printed wiring board obtained in step 4 into the cleaning solution or spraying the printed wiring board with the cleaning solution, for example using a sprayer. As for the temperature of the cleaning solution, it can be used at room temperature (25°C). The cleaning solution, however, may be used with a temperature setting of, for example, 30°C. This helps ensure that the cleaning is performed in a stable manner, without being influenced by the ambient temperature.

The step of removing the electrically conductive metal layer in the no-pattern region (NPM1) using an etchant and the cleaning operation in step 4 can be repeated as necessary.

A metal pattern layer (PM1) formed in a production method according to the present invention may have its surface covered, primarily to protect the metal layer itself, with another type of metal layer formed by electroless plating. For example, if the metal pattern formed is a conductor-circuit pattern, a patterned metal layer (PM2) made of copper may optionally be subjected to nickel/gold plating, nickel/palladium/gold plating, or palladium/gold plating as necessary.

The above-described methods according to the present invention for producing a shaped article having a metal pattern allow the manufacturer to produce a shaped article in a planar or three-dimensional solid shape that has a strongly adhering and smooth-surfaced metal pattern on its surface without requiring complicated double molding or troublesome operations such as exposure and development using a photoresist in a darkroom and without the use of expensive vacuum equipment. By the methods according to the present invention for producing a shaped article having a metal pattern, therefore, manufacturers can provide high-density and high-performance printed wiring boards and molded interconnect devices (MID) in different shapes and sizes at low cost. Thus the present invention has high industrial applicability in the field of printed wiring. The methods according to the present invention for producing a shaped article having a metal pattern can also be used for various electronic components that have a patterned metal layer on the surface of a substrate. For example, the methods can also be applied to connectors, shields against electromagnetic waves, and RFID and other antennas.

The purposes of use of shaped articles having a metal pattern produced by the methods according to the present invention for producing a shaped article having a metal pattern, furthermore, are not limited to electronic components but also include functional components, decorative plating, etc., that have a patterned metal layer on shaped articles in different shapes and sizes.

### EXAMPLES

The following describes the present invention in detail by examples.

### [Production Example 1: Production of Primer (B-1)]

In a nitrogen-purged vessel equipped with a thermometer, a gaseous nitrogen inlet tube, and a stirrer, 100 parts by mass of a polyester polyol (polyester polyol obtained by reacting 1,4-cyclohexanedimethanol, neopentyl glycol, and adipic acid together), 17.6 parts by mass of 2,2-dimethylolpropionic acid, 21.7 parts by mass of 1,4-cyclohexanedimethanol, and 106.2 parts by mass of dicyclohexylmethane-4,4'-diisocyanate were allowed to react in a solvent mixture of 178 parts by mass of methyl ethyl ketone to give a solution of a urethane prepolymer having a terminal isocyanate group.

Then 13.3 parts by mass of triethylamine was added to the urethane prepolymer solution to neutralize carboxyl groups in the urethane prepolymer. The resulting mixture was stirred thoroughly with 380 parts by mass of water to give an aqueous liquid dispersion of a urethane prepolymer.

The resulting aqueous liquid dispersion of a urethane prepolymer was stirred with 8.8 parts by mass of a 25% by mass aqueous solution of ethylenediamine to extend the chains of the urethane prepolymer. Then the dispersion was aged, and the solvent was removed to give an aqueous liquid dispersion of a urethane resin (non-volatile content, 30% by mass). The weight-average molecular weight of the urethane resin was 53,000.

Then 140 parts by mass of deionized water and 100 parts by mass of the above aqueous liquid dispersion of a urethane resin were put into a reactor equipped with a stirrer, a reflux condenser, a nitrogen inlet tube, a thermometer, a dropping funnel for adding a mixture of monomers, and a dropping funnel for adding a polymerization catalyst, and the temperature was increased to 80°C with nitrogen blown into the reactor. Then, with stirring, a mixture of monomers consisting of 60 parts by mass of methyl methacrylate, 30 parts by mass of n-butyl acrylate, and 10 parts by mass of N-n-butoxymethylacrylamide and 20 parts by mass of a 0.5% by mass aqueous solution of ammonium persulfate were added dropwise from separate dropping funnels over 120 minutes with the temperature inside the reactor kept at 80°C.

After the end of addition, the mixture was stirred for another 60 minutes at the same temperature. Then the temperature inside the reactor was cooled to 40°C, the mixture was diluted with deionized water to a non-volatile content of 20% by mass, and the dilution was filtered through a 200-mesh filter cloth. This gave a water dispersion of a primer-layer resin composition that was a core-shell composite resin having a shell layer formed by the urethane resin and a core layer formed by an acrylic resin made from methyl methacrylate and other monomers. Then this water dispersion was combined and mixed with isopropyl alcohol and deionized water to an isopropanol/water ratio by mass of 7/3 and a non-volatile content of 2% by mass. In this way, primer (B-1) was obtained.

### [Production Example 2: Production of Primer (B-2)]

To a reactor equipped with a stirrer, a reflux condenser, a nitrogen inlet tube, a thermometer, and dropping funnels were added 350 parts by mass of deionized water and 4 parts by mass of a surfactant (Kao Corporation "LATEMUL E-118B": 25% by mass active ingredient). The temperature was increased to 70°C with nitrogen blown into the reactor.

A mixture of vinyl monomers consisting of 47.0 parts by mass of methyl methacrylate, 5.0 parts by mass of glycidyl methacrylate, 45.0 parts by mass of n-butyl acrylate, and 3.0 parts by mass of methacrylic acid was mixed with 4 parts by mass of a surfactant (DKS Co., Ltd. "AKUARON (HITENOL) KH-1025": 25% by mass active ingredient) and 15 parts by mass of deionized water to give a monomer preemulsion. Part of this monomer preemulsion (5 parts by mass) and then 0.1 parts by mass of potassium persulfate were added to the reactor with stirring, and the monomers were polymerized for 60 minutes with the temperature inside the reactor kept at 70°C.

Then with the temperature inside the reactor kept at 70°C, the rest of the monomer preemulsion (114 parts by mass) and 30 parts by mass of an aqueous solution of potassium persulfate (1.0% by mass active ingredient) were added dropwise over 180 minutes, using a different dropping funnel for each. After the end of addition, the mixture was stirred for 60 minutes at the same temperature.

The temperature inside the reactor was cooled to 40°C, then deionized water was used to make the non-volatile content 10.0% by mass, and the resulting liquid was filtered through a 200-mesh filter cloth to give a primer-layer resin composition to be used in the present invention. Then this resin composition was diluted and mixed with added water. In this way, primer (B-2) was obtained with a non-volatile content of 5% by mass.

### [Production Example 3: Production of Primer (B-3)]

A reactor equipped with a thermometer, a gaseous nitrogen inlet tube, and a stirrer was charged with 830 parts by mass of terephthalic acid, 830 parts by mass of isophthalic acid, 685 parts by mass of 1,6-hexanediol, 604 parts by mass of neopentyl glycol, and 0.5 parts by mass of dibutyltin oxide with gaseous nitrogen introduced thereinto. Polycondensation was carried out at 230°C for 15 hours to an acid value of 1 or less at 180°C to 230°C to give a polyester polyol having a hydroxy value of 55.9 and an acid value of 0.2.

Then 1,000 parts by mass of this polyester polyol was dehydrated at 100°C under reduced pressure, cooled to 80°C, and then thoroughly stirred with 883 parts by mass of methyl ethyl ketone to dissolve. The resulting solution was combined with 80 parts by mass of 2,2-dimethylolpropionic acid and then 244 parts by mass of isophorone diisocyanate, and the resulting mixture was allowed to react at 70°C for 8 hours.

After the end of the reaction, the mixture was cooled to 40°C, neutralized with 60 parts by mass of triethylamine, and then mixed with 4700 parts by mass of water to give a transparent reaction product. Methyl ethyl ketone was removed from the reaction product at 40°C to 60°C under reduced pressure, and then the residue was mixed with water. In this way, primer (B-3) was obtained with a solids content of 10% by mass.

### [Preparation Example 1: Preparation of a Liquid Dispersion of Silver Particles]

A dispersion containing silver particles and a dispersant was prepared by dispersing silver particles having an average diameter of 30 nm in a solvent mixture of 45 parts by mass of ethylene glycol and 55 parts by mass of deionized water using a compound of polyethylene imine with added polyoxyethylene as a dispersant. The resulting dispersion was then combined with deionized water, ethanol, and a surfactant to give a 5% by mass liquid dispersion of silver particles.

### [Preparation Example 2: Preparation of a Silver Etchant]

A silver etchant was prepared by adding 2.6 parts by mass of acetic acid and then 50 parts by mass of a 35% by mass aqueous solution of hydrogen peroxide to 47.4 parts by mass of water. The molar ratio between hydrogen peroxide and the carboxylic acid (hydrogen peroxide/carboxylic acid) in this silver etchant was 13.6. The percentage of the mixture of hydrogen peroxide and a carboxylic acid in silver etchant (1) was 22.4% by mass.

### [Preparation Example 4: Preparation of Black-Colored Primer (B-4)]

Black-colored primer (B-4) having a non-volatile content of 6% was prepared by mass by adding 2 parts by mass of a black colorant (DIC Corporation "DILAC BLACK HS9530") to 100 parts by mass of primer (B-3), obtained in Production Example 3 and stirring the resulting mixture with isopropanol.

### [Fabrication Example 1: Fabrication of a Polyphenylene Sulfide (PPS) Shaped Article]

One hundred parts by mass of a linear polyphenylene sulfide (MFR as per ASTM D1238-86: 600 g/10 min) was uniformly mixed with 58.8 parts by mass of chopped glass fiber (Asahi Fiber Glass Co., Ltd. "FT562," a fibrous inorganic filler), 8.4 parts by mass of an ethylene-methacrylic acid copolymer with zinc ions (DuPont Mitsui Chemicals Co., Ltd. "Himilan 1855"), and 0.8 parts by mass of a montanate-based composite wax (Clariant Japan K.K. "Licolub WE40"). The resulting mixture was then melt-kneaded at 290°C to 330°C using a 35-mm-diameter twin-screw extruder to give a polyphenylene sulfide resin composition. The resulting polyphenylene sulfide resin composition was shaped using an injection molding machine to give a PPS shaped article having a size of 50 mm × 105 mm × 2 mm.

### (Example 1)

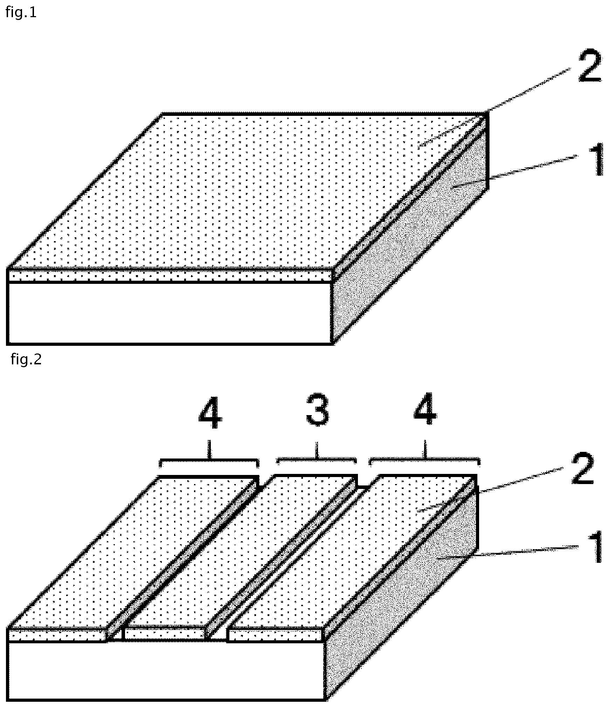

An electrically conductive metal layer containing silver particles was formed on the surface of a polyimide film (Du Pont-Toray Co., Ltd. "Kapton 150EN-C"; thickness, 38 µm) by coating the surface of the polyimide film with the liquid dispersion of silver particles obtained in Preparation Example 1 using a tabletop small coater (RK PrintCoat Instruments "K Printing Proofer") to an average dry thickness of 60 nm and drying the resulting coating at 200°C for 30 minutes using a hot-air dryer (Fig. 1).

Using a laser marker (Keyence Corporation "MD-V9900A"; a YVO4 laser; wavelength, 1,064 nm), the electrically conductive metal layer was irradiated with laser light at a laser intensity of 50%, a scan speed of 500 mm/sec, and a frequency of 50 kHz to separate the layer into a linear pattern region (3 in Fig. 2) and a no-pattern region (4 in Fig. 2). The pattern region was a 200-µm-wide linear pattern.

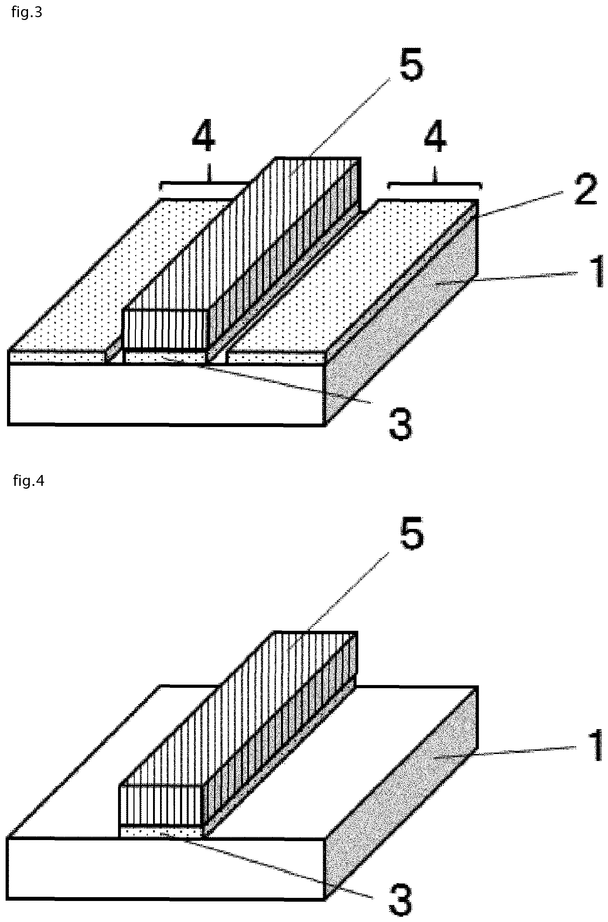

Then, with the electrically conductive metal layer in the pattern region (3 in Fig. 2) set as the cathode and phosphorus-containing copper as the anode, the workpiece was subjected to 20 minutes of electrolytic plating at a current density of 2.5 A/dm² using an electrolytic plating solution containing copper sulfate (copper sulfate, 70 g/L; sulfuric acid, 200 g/L; chloride ions, 50 mg/L; and an additive (Okuno Chemical Industries Co., Ltd. "TOP LUCINA SF-M") to form a patterned metal layer (thickness, 10 µm) of electrolytic copper plating having a line width of 200 µm in the pattern region (Fig. 3).

The electrically conductive metal layer in the no-pattern region was removed by immersing the resulting film in the silver etchant prepared in Preparation Example 2 above at 25°C for 3 minutes. In this way, a shaped article having a metal pattern was obtained (Fig. 4).

### (Example 2)

A shaped article having a metal pattern was obtained by forming a linear patterned metal layer of copper having a 200 µm of line width and a thickness of 10 µm on a polyimide film as in Example 1, except that the thickness of the electrically conductive metal layer containing silver particles was changed from 60 nm to 100 nm, and the duration of immersion in the silver etchant was changed from 3 minutes to 5 minutes.

### (Example 3)

A primer layer was formed on the surface of a polyimide film (Du Pont-Toray Co., Ltd. "Kapton 150EN-C"; thickness, 38 µm) by coating the surface of the polyimide film with primer (B-1), obtained in Production Example 1, using a tabletop small coater (RK PrintCoat Instruments "K Printing Proofer") to a dry thickness of 100 nm and then drying the resulting coating at 80°C for 5 minutes using a hot-air dryer

Then an electrically conductive metal layer containing silver particles was formed on the surface of the primer layer by coating the surface of the primer layer with the liquid dispersion of silver particles obtained in Preparation Example 1 using a tabletop small coater (RK PrintCoat Instruments "K Printing Proofer") to an average dry thickness of 250 nm and then drying the resulting coating at 200°C for 30 minutes using a hot-air dryer. After the formation of the electrically conductive metal layer, the same process as in Example 2 was followed to obtain a shaped article having a metal pattern.

### (Example 4)

The PPS shaped article obtained in Fabrication Example 1 was used. A primer layer (thickness, 130 nm) was formed on the PPS shaped article by immersing the PPS shaped article in primer (B-2), obtained in Production Example 2, for 10 seconds, removing and allowing the shaped article to stand for 1 minute, and then drying it at 200°C for 5 minutes using a hot-air dryer.

Then a 100-nm thick electrically conductive metal layer containing silver particles was formed on the primer layer by immersing this PPS shaped article, with the primer layer thereon, in the liquid dispersion of silver particles obtained in Preparation Example 1, for 10 seconds, removing and allowing the PPS shaped article to stand for 1 minute, and then drying it at 200°C for 5 seconds. After the formation of the electrically conductive metal layer, the same process as in Example 3 was followed to obtain a shaped article having a metal pattern.

### (Example 5)

An electrically conductive metal layer containing silver particles was formed on a primer layer as in Example 3, except that the polyimide film, used in Example 3, was replaced with a polyethylene naphthalate (hereinafter abbreviated to "PEN") film (Teijin Film Solutions Limited "Teonex Q51"; 25-µm-thick), primer (B-1) was replaced with primer (B-3), obtained in Production Example 3, and the temperature for the drying after the coating with the liquid dispersion of silver particles was changed to 150°C. After the formation of the electrically conductive metal layer, the same process as in Example 3 was followed to obtain a shaped article having a metal pattern.

### (Example 6)

A shaped article having a linear metal pattern of copper with a line width of 200 µm and a thickness of 10 µm on a polyethylene naphthalate film with a black primer layer thereon was obtained as in Example 5, except that primer (B-3), used in Example 3, was replaced with black primer (B-4), and the laser intensity of the laser marker was changed from 50% to 30%.

### (Comparative Example 1)

A nickel/chromium layer (thickness, 30 nm; nickel/chromium ratio by mass = 8/2) and then a copper layer (thickness, 100 nm) were formed on the surface of a polyimide film (Du Pont-Toray Co., Ltd. "Kapton 150EN-C"; thickness, 38 µm), both by sputtering. The resulting stack was used as the electrically conductive metal layer.

As in Example 1, a 200-µm-wide linear pattern region was created on the electrically conductive metal layer using a laser marker. The electrically conductive metal layer, which was a metal layer formed by sputtering and therefore was a continuous film, swelled along its laser-cut edges. In the subsequent step of electrolytic plating, the edges of the metal pattern were lifted. The pattern formed was therefore uneven.

The resulting film was immersed for 5 minutes in a 10% by mass aqueous solution of sodium persulfate, which is used for etching of a copper seed. The copper in the electrically conductive metal layer, except in the pattern region, was removed, but the nickel/chromium layer was not removed but remained. Along with this, undercuts were observed as a result of the etching of the sputter-deposited copper layer lying between the metal pattern layer formed by electrolytic plating and the nickel/chromium layer. The aforementioned lifted portions of the patterned metal layer therefore detached.

### (Comparative Example 2)

The PPS shaped article obtained in Fabrication Example 1 above was used. A nickel layer (thickness, 300 nm) and then a copper layer (thickness, 100 nm) were formed on the surface of the shaped article, both by sputtering. The resulting stack was used as the electrically conductive metal layer.

As in Example 1, a 200-µm-wide linear pattern region was created on the electrically conductive metal layer using a laser marker. The electrically conductive metal layer, which was a metal layer formed by sputtering and therefore was a continuous film, swelled along its laser-cut edges. In the subsequent step of electrolytic plating, the edges of the metal pattern were lifted. The pattern formed was therefore uneven.

The resulting electrolytically plated PPS shaped article was immersed for 5 minutes in a 10% by mass aqueous solution of sodium persulfate, which is used for etching of a copper seed. The copper in the electrically conductive metal layer, except in the pattern region, was removed, but the nickel layer was not removed but remained. Along with this, undercuts were observed because copper was etched in the metal pattern layer formed by electrolytic plating, too. The patterned metal layer therefore detached.

The shaped articles having a metal pattern obtained in Examples 1 to 6 above were tested by checking for electrical continuity between wires using a multimeter, measuring the insulation resistance, measuring the insulation resistance in the no-pattern region, measuring the peel strength, checking for undercuts, and examining the cross-sectional shape of the patterned metal layer, in the pattern region, as follows.

### [Measurement of the Insulation Resistance of the Portion in the No-Pattern Region]

The shaped articles having a metal pattern obtained were subjected to the measurement of resistance in their portion in the no-pattern region (region excluding the patterned metal layer portion and from which silver had been removed) at an applied voltage of 100 V using Mitsubishi Chemical Analytic Co., Ltd.'s Hiresta-UP (model MCP-HT450). According to the specifications for the analyzer, an "OVER" resistance reading (overload) indicates that the resistance is at least 9.99 × 10¹³ Ω.

### [Check for Undercuts and Examination of the Cross-Sectional Shape in the Pattern Portion]

The printed wiring boards obtained were examined for undercuts and their cross-sectional shape by observing a cross-section of their pattern portion (portion formed by the electrically conducting metal layer and the patterned metal layer) at a magnification of 500 to 10,000 under a scanning electron microscope (JEOL "JSM7800").

### [Measurement of Peel Strength]

In Examples 1 to 6 above, a test specimen was prepared after the formation of the electrically conductive metal layer by creating a linear pattern region having a line width of 1 cm and 30 minutes of plating with copper sulfate in the same way as described above. The resulting test specimen, having a 15-µm-thick patterned metal layer of copper plating, was subjected to the measurement of peel strength by a 90° peeling test using Seishin Trading Co., Ltd.'s "High Precision Bond Tester SS-30WD."

A summary of measurement results for the shaped articles having a metal pattern obtained in Examples 1 to 6 is presented in Table 1.

**[Table 1]**

| | Example 1 | Example 2 | Example 3 | Example 4 | Example 5 | Example 6 |
|---|---|---|---|---|---|---|
| Electrically insulating shaped article | Polyimide film | Polyimide film | Polyimide film | PPS shaped article | PEN film | PEN film |
| Primer | None | None | B-1 | B-2 | B-3 | B-4 |
| Electrically conductive metal layer | Silver particles | Silver particles | Silver particles | Silver particles | Silver particles | Silver particles |
| Thickness (nm) of the electrically conductive metal layer (M1) | 60 | 100 | 100 | 100 | 100 | 100 |
| Hydrogen peroxide/carboxylic acid molar ratio | 13.6 | 13.6 | 13.6 | 13.6 | 13.6 | 13.6 |
| Resistance in the no-pattern region (Ω) | Overload | Overload | Overload | Overload | Overload | Overload |
| Undercuts in the pattern portion | No | No | No | No | No | No |
| Cross-sectional shape in the pattern portion | Rectangular | Rectangular | Rectangular | Rectangular | Rectangular | Rectangular |
| 90° peel strength (N/m) | 657 | 618 | 726 | 691 | 611 | 631 |

### Reference Signs List

1: Electrically insulating shaped article
2: Electrically conductive metal layer
3: Electrically conductive metal layer in the pattern region
4: Electrically conductive metal layer in the no-pattern region
5: Patterned metal layer

## Claims

1. A method for producing a shaped article having a metal pattern on an electrically insulating shaped article, the method comprising:
step 1, forming an electrically conductive metal layer (M1) on an electrically insulating shaped article (A), the electrically conductive metal layer (M1) containing silver particles;
step 2, removing part of the electrically conductive metal layer (M1) to separate the electrically conductive metal layer (M1) into an electrically conductive metal layer in a pattern region (PM1), the pattern region being a region in which the pattern is to be formed, and an electrically conductive metal layer in a no-pattern region (NPM1), the no-pattern region being a region in which the pattern is not to be formed;
step 3, forming a patterned metal layer (PM2) on the electrically conductive metal layer in the pattern region (PM1) by electrolytic plating; and
step 4, removing the electrically conductive metal layer in the no-pattern region (NPM1) using an etchant.

2. A method for producing a shaped article having a metal pattern on an electrically insulating shaped article, the method comprising:
step 1', forming a primer layer (B) on an electrically insulating shaped article (A) and then forming an electrically conductive metal layer (M1) on the primer layer (B), the electrically conductive metal layer (M1) containing silver particles;
step 2, removing part of the electrically conductive metal layer (M1) to separate the electrically conductive metal layer (M1) into an electrically conductive metal layer in a pattern region (PM1), the pattern region being a region in which the pattern is to be formed, and an electrically conductive metal layer in a no-pattern region (NPM1), the no-pattern region being a region in which the pattern is not to be formed;
step 3, forming a patterned metal layer (PM2) on the electrically conductive metal layer in the pattern region (PM1) by electrolytic plating; and
step 4, removing the electrically conductive metal layer in the no-pattern region (NPM1) using an etchant.

3. The method according to Claim 1 or 2 for producing a shaped article, wherein in step 2, the removal of part of the electrically conductive metal layer (M1) is by irradiation with electromagnetic waves.

4. The method according to Claim 3 for producing a shaped article, wherein in the method according to Claim 2 for producing a shaped article, the primer layer (B) contains a substance that absorbs the electromagnetic waves.

5. The method according to any one of Claims 1 to 4 for producing a shaped article, wherein the etchant contains a carboxylic acid and hydrogen peroxide as active ingredients.

6. The method according to any one of Claims 1 to 5 for producing a shaped article, wherein the silver particles have been coated with at least one polymeric dispersant.

7. The method according to Claim 6 for producing a shaped article, wherein in the method according to Claim 2 for producing a shaped article, the primer layer (B) is made with a resin having at least one reactive functional group [X], the polymeric dispersant has a reactive functional group [Y], and the reactive functional group [X] and the reactive functional group [Y] are allowed to bind together.

8. The method according to Claim 7 for producing a shaped article, wherein the reactive functional group [Y] is a group that contains a basic nitrogen atom.

9. The method according to Claim 7 for producing a shaped article, wherein the polymeric dispersant, having the reactive functional group [Y], is one or more selected from the group consisting of polyalkyleneimines and of polyalkyleneimines having a polyoxyalkylene structure including an oxyethylene unit.

10. The method according to any one of Claims 7 to 9 for producing a shaped article, wherein the reactive functional group [X] is one or more selected from the group consisting of a keto group, an acetoacetyl group, an epoxy group, a carboxyl group, an N-alkylol group, an isocyanate group, a vinyl group, a (meth)acryloyl group, and an allyl group.
